# EUROPÄISCHE PATENTSCHRIFT

(11) **EP 1 455 044 B1**
(45) Veröffentlichungstag und Bekanntmachung des Hinweises auf die Patenterteilung: **06.05.2009**
(21) Anmeldenummer: 04005107.0
(22) Anmeldetag: 04.03.2004
(51) Int. Cl.: E05F 15/00

(54) **Vorrichtung zum Erkennen eines Hindernisses in dem Öffnungsbereich eines bewegbaren Schliesselements**
Device for detecting an obstacle in the opening area of a mobile closing element
Dispositif pour détecter un obstacle dans la zone d'ouverture d'un élément mobile de fermeture

(30) Priorität: 07.03.2003 DE 10310066
(43) Veröffentlichungstag der Anmeldung: 08.09.2004
(73) Patentinhaber: Metzeler Automotive Profile Systems GmbH, 88131 Lindau/Bodensee (DE)
(72) Erfinder: Regnet, Helmut, 88131 Lindau (DE); Kopp, Günther, 88085 Langenargen (DE)
(74) Vertreter: Schober, Christoph D.

(56) Entgegenhaltungen:
- EP-A- 1 154 110
- US-A- 5 027 552

## Beschreibung

Die Erfindung betrifft eine Vorrichtung zum Erkennen eines Hindernisses in dem Öffnungsbereich eines bewegbaren Schliesselements. Bei dem Schliesselement kann es sich beispielsweise um eine elektrisch angetriebene Fensterscheibe oder ein Schiebedach eines Kraftfahrzeugs handeln. Die Vorrichtung ist mit einer Sensorelektrode, die ein erstes und ein zweites Ende aufweist, einer von der Sensorelektrode beabstandeten Grundelektrode, die ein erstes und ein zweites Ende aufweist, und einer mit dem ersten Ende der Sensorelektrode und mit dem ersten Ende der Grundelektrode verbundenen Auswerteeinheit versehen. Die Sensorelektrode und die Grundelektrode erzeugen ein elektrisches Feld in dem Öffnungsbereich des Schliesselements und weisen in einem ersten Betriebsmodus einen konstanten Abstand zueinander auf. Die Auswerteeinheit erfasst in dem ersten Betriebsmodus eine auf Grund der Anwesenheit eines Hindernisses in dem elektrischen Feld hervorgerufene kapazitive Änderung und stellt ein Steuersignal für einen das Schliesselement bewegenden Antrieb bereit.

Eine derartige Vorrichtung stellt einen Einklemmschutz dar, der dazu dient, das Einklemmen von beispielsweise einem menschlichen Körperteil zwischen dem Schliesselement und einem das Schliesselement zumindest teilweise einfassenden Rahmen zu verhindern. Nach der Arbeitsweise lassen sich die bekannten Vorrichtungen unterteilen in einen direkt und einen indirekt arbeitenden Einklemmschutz, wie beispielsweise die DE 199 06 562 A1 beschreibt. Unter einem direkt arbeitenden Einklemmschutz werden Vorrichtungen oder Systeme verstanden, die Sensoren aufweisen, welche ein Hindernis direkt erfassen und ein entsprechendes Signal an einen beispielsweise eine Fensterscheibe antreibenden Elektromotor übermitteln. Im Unterschied hierzu wird bei einem indirekt arbeitenden Einklemmschutz die auf den Elektromotor wirkende Last erfasst und die Anwesenheit eines Hindernisses durch eine Verarbeitung der spezifischen Parameter des Elektromotors ermittelt. Für einen direkt arbeitenden Einklemmschutz können die unterschiedlichsten Sensoren Anwendung finden. In Abhängigkeit von der Art des Sensors lassen sich die bekannten Vorrichtungen unterteilen in einen Einklemmschutz, der einen physischen Kontakt des Hindernisses erfordert, und einen Einklemmschutz, der berührungslos arbeitet.

Ein zu der ersten Gruppe zu zählender Einklemmschutz wird in der EP 0 638 701 B1 beschrieben. Dieser taktile Einklemmschutz weist eine Dichtung auf, die ein Schliesselement abdichtet und mit zwei voneinander beabstandeten, elektrisch leitfähigen Bereichen versehen ist. Bei einem physischen Kontakt mit einem in dem Öffnungsbereich des Schliesselements befindlichen Hindernis werden die leitfähigen Bereiche aneinandergedrückt, wodurch sich ein Schaltkontakt ergibt, der ein elektrisches Steuersignal auslöst. Ein taktiler Einklemmschutz wird ausserdem in der DE 199 13 105 A1 beschrieben.

Demgegenüber ist aus der EP 0 648 628 B1 ein berührungslos arbeitender Einklemmschutz bekannt. Der bekannte Einklemmschutz weist eine extrudierte Dichtung auf, in die ein elektrischer Leiter integriert ist. Der elektrische Leiter stellt eine Sensorelektrode dar, die ein elektrisches Feld in dem Öffnungsbereich einer Fensterscheibe erzeugt. Änderungen der Kapazität auf Grund des Vorhandenseins eines Hindernisses in dem elektrischen Feld werden durch eine Auswerteeinheit erfasst, die ein Steuersignal für einen die Fensterscheibe antreibenden Motor bereitstellt. Für den Fall, dass dennoch ein Hindernis in Kontakt mit der Dichtung gelangt, ist eine Umkehrung der Antriebsrichtung des Motors vorgesehen, sobald die von dem Hindernis auf die Fensterscheibe ausgeübte Kraft einen vorgegebenen Maximalwert von beispielsweise 100 N übersteigt. Bei dem bekannten Einklemmschutz kann eine ein Steuersignal für den Motor auslösende kapazitive Änderung auch dann erreicht werden, wenn eine in eine beweglich angeordnete Lippe integrierte Sensorelektrode durch ein Hindernis in ihrer Lage verändert wird.

Die DE 43 20 548 C2 offenbart eine Vorrichtung zum Öffnen und Schliessen eines Seitenfensters eines Kraftfahrzeugs, die eine Prüfschaltung aufweist, welche einen Antrieb des Seitenfensters in Folge eines Sensorsignals unterbricht oder reversiert. Das Sensorsignal wird durch Messung des kapazitiven Widerstands zwischen zwei elektrisch leitenden Schlitzbegrenzungen ermittelt, indem beispielsweise ein Schwingkreis oder eine Wheatstone'sche Messbrücke verstimmt wird. Eine der Schlitzbegrenzungen wird durch eine das Seitenfenster abdichtende Dichtung gebildet. Die andere Schlitzbegrenzung wird entweder durch eine elektrisch leitfähige Oberkante des Seitenfensters oder, wenn dieses ausreichend leitfähig ist, durch das Seitenfenster selbst gebildet. Eine kapazitive Änderung ergibt sich dann, wenn sich ein Hindernis in einem Schlitz zwischen den Schlitzbegrenzungen befindet. Nachteilig bei der bekannten Vorrichtung ist, dass der Abstand der Elektroden darstellenden Schlitzbegrenzungen durch die Bewegung des Seitenfensters verändert wird, so dass die sich hieraus ergebende kapazitive Änderung bei der Generierung des Steuersignals berücksichtigt werden muss.

Ein berührungslos arbeitender Einklemmschutz wird ferner in der EP 1 154 110 A2 beschrieben. Die Wirkungsweise des bekannten Einklemmschutzes beruht auf einer durch ein elektrisch leitendes Hindernis, das sich in einem zwischen zwei elektrischen Leitern erzeugten elektrischen Felds befindet, hervorgerufenen Änderung der Kapazität. Einer der beiden Leitern, die Sensorelektrode, ist in einer ein Schliesselement abdichtenden Dichtung integriert und wird mit einer vorgegebenen elektrischen Ladung beaufschlagt. Auf diese Weise lässt sich zwischen der Sensorelektrode und dem anderen Leiter, der Grundelektrode, die beispielsweise auf Masse liegt, eine Messkapazität bestimmen. Die Änderung der Messkapazität durch ein Hindernis wird mittels einer Auswerteeinheit erfasst, die ein Steuersignal für einen das Schliesselement bewegenden Antrieb bereitstellt. Um auch nicht leitende Werkstoffe, wie beispielsweise Holz oder Kunststoff, die keine oder nur eine geringe kapazitive Änderung hervorrufen, erkennen zu können, ist der kapazitive Einklemmschutz mit einem sogenannten Softspot versehen. Der Softspot wird dadurch realisiert, dass der die Sensorelektrode aufnehmende Bereich der Dichtung verformbar ausgestaltet ist. Auf diese Weise ergibt sich bei einem Kontakt des Hindernisses mit der Dichtung eine Veränderung der relativen Lage von Sensorelektrode und Grundelektrode, die zu einer kapazitiven Änderung führt.

Die letztgenannte Druckschrift offenbart überdies Methoden zur Überwachung der Funktionsfähigkeit von Sensorelektrode und Grundelektrode. Eine erste Methode besteht darin, die Sensorelektrode in Form einer Schleife auszugestalten und am offenen Ende mit einem Gleichspannungssignal zu beaufschlagen. Eine zweite Methode sieht vor, eine ein freies Ende aufweisende Sensorelektrode mit einem vorgegebenen Signal zu beaufschlagen, das am freien Ende reflektiert wird. Aus Laufzeitunterschieden lässt sich somit beispielsweise eine Unterbrechung der Sensorelektrode erkennen. Eine dritte Methode besteht darin, die Kapazität zwischen Sensorelektrode und Grundelektrode mit einer vorgegebenen Messkapazität zu vergleichen.

Eine redundant ausgestaltete Vorrichtung zum Erkennen eines Hindernisses im Bereich einer Schließkante eines Tores wird in der US 5,027,552 beschrieben. Für die redundante Ausgestaltung weist die Vorrichtung einen kapazitiven Einklemmschutz und einen taktilen Einklemmschutz auf. Der taktile Einklemmschutz ist entweder mittels eines Kraftsensors oder mittels eines Drucksensors realisiert. Der Kraftsensor weist eine äußere Hülle auf, die aus einem biegsamen Material besteht. In der äußeren Hülle sind drei Schichten angeordnet, die aus einem nicht leitenden Werkstoff bestehen. Zwischen den äußeren Schichten und der inneren Schicht ist jeweils eine elektrische leitfähige Schicht angeordnet, die durch eine Aluminiumfolie gebildet wird. Um einen Kontakt der elektrisch leitfähigen Schichten zu ermöglichen, ist die mittlere Schicht mit Öffnungen versehen. Der kapazitive Einklemmschutz weist eine Sensorelektrode auf, die durch eine der elektrisch leitfähigen Schichten gebildet sein kann. Der durch den Kraftsensor gebildete taktile Einklemmschutz und der durch die Sensorelektrode gebildete kapazitive Einklemmschutz arbeiten simultan, um die Ausfallsicherheit zu erhöhen und Objekte, die keine kapazitive Änderung bewirken, erfassen zu können.

Außerdem wird in der US 6,389,752 B1 eine Methode zur Überwachung der Funktionsfähigkeit eines taktilen Einklemmschutzes beschrieben. Die bekannte Methode besteht darin, zwischen zwei elektrischen Leitungen einen Widerstand zu schalten, der eine konstante Impedanz bereitstellt. Der Widerstand reflektiert einen auf die Leiter aufgegebenen Signalimpuls, dessen Laufzeit von einer Auswerteeinheit ermittelt wird. Eine Beeinträchtigung der Funktionsfähigkeit des Einklemmschutzes wird durch unterschiedliche Laufzeiten erkannt.

Als Nachteil der berührungslos arbeitenden Vorrichtungen hat sich herausgestellt, dass das durch die Sensorelektrode erzeugte elektrische Feld Störeinflüssen unterliegt, welche die Funktionsfähigkeit und Betriebssicherheit beeinträchtigen können. So macht sich beispielsweise die Bewegung des Schliesselements als störender Einfluss auf die Messkapazität bemerkbar. Darüber hinaus können auf Grund elektromagnetischer Einwirkungen Funktionsstörungen auftreten. Eine ausreichende elektromagnetische Verträglichkeit (EMV) liesse sich zwar prinzipiell durch eine elektronische Kompensationsschaltung realisieren, dies ist aber mit einem verhältnismässig hohen Aufwand verbunden.

Der Erfindung liegt die Aufgabe zugrunde, eine Vorrichtung der eingangs genannten Art dahingehend weiterzubilden, dass sich auf vergleichsweise einfache und kostengünstige Weise eine hohe Betriebs- und Ausfallsicherheit erzielen lässt.

Zur Lösung dieser Aufgabe ist bei einer Vorrichtung mit den oben genannten Merkmalen in Übereinstimmung mit Anspruch 1 erfindungsgemäss vorgesehen, dass die Sensorelektrode und die Grundelektrode an dem zweiten Ende durch ein elektronisches Bauelement miteinander verbunden sind, wobei eine Prüfspannung an die Sensorelektrode und die Grundelektrode angelegt ist und wobei die Sensorelektrode und die Grundelektrode in einem zweiten Betriebsmodus einen veränderlichen Abstand zueinander aufweisen und die Auswerteeinheit in dem zweiten Betriebsmodus zusätzlich bei einem elektrischen Kontakt von Sensorelektrode und Grundelektrode ein Steuersignal für den das Schliesselement bewegenden Antrieb bereitstellt.

Die erfindungsgemässe Vorrichtung macht sich die Erkenntnis zueigen, einen kapazitiven und einen taktilen Einklemmschutz in funktioneller Einheit miteinander zu kombinieren, um eine hohe Betriebs- und Ausfallsicherheit zu erreichen. Wird beispielsweise das in dem Öffnungsbereich des Schliesselements erzeugte elektrische Feld gestört und damit eine zuverlässige Erkennung eines Hindernisses in dem Öffnungsbereich durch Auswertung der kapazitiven Änderung beeinträchtigt oder gar verhindert, so gewährleistet der bei einem elektrischen Kontakt von Sensorelektrode und Grundelektrode gebildete taktile Einklemmschutz, dass ein Steuersignal für den das Schliesselement bewegenden Antrieb dennoch bereitgestellt wird. Die sich durch den zusätzlichen taktilen Einklemmschutz ergebende Redundanz gewährleistet somit eine hohe Betriebssicherheit. Darüber hinaus ermöglicht der taktile Einklemmschutz eine einfache und damit kostengünstige Ausgestaltung der Auswerteeinheit. Denn der der Auswerteeinheit zugrundeliegende elektronische Schaltkreis bedarf im Grunde keiner Bauelemente, die elektromagnetische Störeinflüsse auf das elektrische Feld kompensieren. Im Vergleich zu der aus der EP 0 648 628 B1 bekannten Kombination eines kapazitiven Einklemmschutzes mit einem indirekt arbeitenden Einklemmschutz zeichnet sich die erfindungsgemässe Vorrichtung durch ein schnelles Ansprechen auch bei relativ geringen Einklemmkräften von beispielsweise 10 N bis 25 N aus.

Indem die Sensorelektrode und die Grundelektrode an dem zweiten Ende durch ein elektronisches Bauelement miteinander verbunden sind und eine Prüfspannung an die Sensorelektrode und die Grundelektrode angelegt ist, lässt sich die Funktionsfähigkeit von Sensorelektrode und Grundelektrode mittels der Prüfspannung permanent überwachen. Eine Funktionsstörung, beispielsweise auf Grund einer Unterbrechung oder eines Kurzschlusses, lässt sich somit unverzüglich erkennen. Bei der Verbindung von Sensorelektrode und Grundelektrode durch das vorzugsweise als auftretende Wechselströme begrenzende Drossel wirkende Bauelement kommt im besonderen Masse die erfindungsgemässe Kopplung von kapazitivem und taktilem Einklemmschutz zum Tragen, die sich in einem synergistischen Effekt in Hinsicht auf eine hohe Ausfall- und Betriebssicherheit zeigt.

Vorteilhafte Weiterbildungen der erfindungsgemässen Vorrichtung stellen die Gegenstände der Ansprüche 2 bis 10 dar.

Von Vorteil ist es, wenn die Auswerteeinheit in dem zweiten Betriebsmodus zusätzlich bei einer Veränderung der relativen Lage von Sensorelektrode und Grundelektrode ein Steuersignal für den das Schliesselement bewegenden Antrieb bereitstellt. Auf diese Weise lässt sich ein aus einem nichtleitenden Werkstoff bestehendes Hindernis, welches das in dem Öffnungsbereich des Schliesselements erzeugte elektrische Feld nicht signifikant beeinflusst, schon dann erkennen, wenn die Lage von Sensorelektrode und Grundelektrode durch das Hindernis relativ zueinander verändert wird.

Von Vorteil ist ferner, wenn das elektronische Bauelement einen ohmschen und/oder induktiven und/oder kapazitiven Widerstand aufweist. Vor allem ein induktiver Widerstand ermöglicht auf einfache Weise eine Begrenzung der sich durch die an die Sensorelektrode und die Grundelektrode angelegte Spannung ergebenden Wechselströme.

In einer bevorzugten Ausgestaltung der erfindungsgemässen Vorrichtung ist eine das Schliesselement abdichtende Dichtung vorgesehen, die aus einem elastisch verformbaren Werkstoff, vorzugsweise Ethylen-Propylen-Dien-Kautschuk (EPDM), gefertigt und an einem das Schliesselement zumindest teilweise einfassenden Rahmen befestigt ist. Die beispielsweise extrudierte Dichtung ermöglicht eine in fertigungstechnischer Hinsicht praxisgerechte Anordnung von Sensorelektrode und Grundelektrode, um in dem Öffnungsbereich des Schliesselements ein elektrisches Feld zu erzeugen. Die Dichtung weist zweckmässigerweise einen Befestigungsabschnitt, der an dem Rahmen angeordnet ist, und wenigstens eine Dichtlippe, die an dem Schliesselement anliegt, auf, um zum einen eine einfache Montage und zum anderen eine zuverlässige Abdichtung sicherzustellen.

Von Vorteil ist ferner, die Sensorelektrode und/oder die Grundelektrode als Metallstränge auszugestalten, die in die Dichtung eingebettet und durch eine Hohlkammer voneinander beabstandet sind. Die Hohlkammer stellt sicher, dass die Sensorelektrode und die Grundelektrode relativ zueinander bewegbar sind, um einen taktilen Einklemmschutz zu realisieren. Durch die Grösse der Hohlkammer lässt sich der Verformungsweg festlegen, der erforderlich ist, um die Sensorelektrode und die Grundelektrode durch ein Hindernis in Kontakt zu bringen. Je nach Ausgestaltung der Hohlkammer kann somit zugleich ein Softspot, wie er in der EP 1 154 110 A2 beschrieben ist, verwirklicht werden, so dass sich eine dreifache Redundanz ergibt.

Die Metallstränge sind bevorzugt im Querschnitt rund, vorzugsweise kreisförmig oder oval, können in Hinsicht auf die Reichweite und die Ausrichtung des elektrischen Felds aber auch polygonal, vorzugsweise rechteckig oder dreieckig, ausgebildet sein. Weiterhin können die Sensorelektrode und/oder die Grundelektrode vorteilhafterweise von elektrisch leitfähigen Bereichen der Dichtung, die durch die Hohlkammer voneinander beabstandet sind, umgeben sein. Die beispielsweise durch Koextrusion gefertigten elektrisch leitfähigen Bereiche schützen die Sensorelektrode und die Grundelektrode vor äusseren Umgebungseinflüssen, beispielsweise Korrosion, und tragen somit zu einer hohen Betriebssicherheit und langen Lebensdauer der erfindungsgemässen Vorrichtung bei. Alternativ können die Sensorelektrode und/oder die Grundelektrode ausschliesslich als elektrisch leitfähige Bereiche der Dichtung ausgestaltet sein, die durch eine Hohlkammer voneinander beabstandet sind.

In einer bevorzugten Ausgestaltung der erfindungsgemässen Vorrichtung erfasst die Auswerteeinheit eine bei Anwesenheit eines Hindernisses in dem Öffnungsbereich des Schliesselements von dem Hindernis auf das Schliesselement ausgeübte Kraft und stellt bei Überschreiten eines vorgegebenen Maximalwerts für die Kraft ein Steuersignal für den das Schliesselement bewegenden Antrieb bereit. Die erfindungsgemässe Vorrichtung verwirklicht auf diese Weise zugleich einen indirekt arbeitenden Einklemmschutz, so dass sich eine vierfache Redundanz in Hinsicht auf das Erkennen eines Hindernisses in dem Öffnungsbereich des Schliesselements realisieren lässt.

Einzelheiten und weitere Vorteile der erfindungsgemässen Vorrichtung ergeben sich aus der nachfolgenden Beschreibung von bevorzugten Ausführungsbeispielen. In den die Ausführungsbeispiele lediglich schematisch darstellenden Zeichnungen veranschaulichen im einzelnen:
- Fig. 1: eine Seitenansicht eines Kraftfahrzeugs;
- Fig. 2: einen Schnitt gemäss der Linie II in Fig. 1;
- Fig. 3: eine schematische Darstellung des Anschlusses einer Sensorelektrode und einer Grundelektrode an eine Auswerteeinheit in einer ersten Ausführungsform;
- Fig. 4: einen Schaltplan der in Fig. 3 gezeigten Auswerteeinheit und
- Fig. 5: eine schematische Darstellung des Anschlusses von Sensorelektrode und Grundelektrode an die Auswerteeinheit in einer zweiten Ausführungsform.

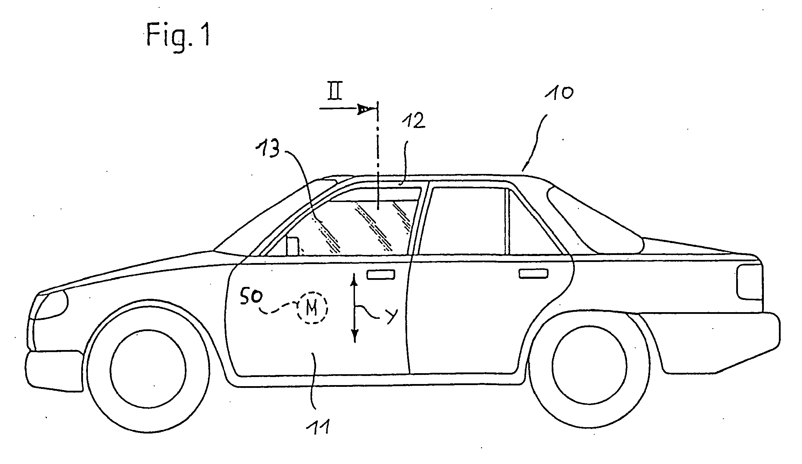

Das in Fig. 1 gezeigte Kraftfahrzeug 10 ist im Bereich einer Tür 11 mit einer durch einen Elektromotor 50 angetriebenen Fensterscheibe 13 versehen. Die ein Schliesselement darstellende Fensterscheibe 13 ist in Antriebsrichtung y des Elektromotors 50 zwischen einer Offenstellung und einer Schliessstellung bewegbar.

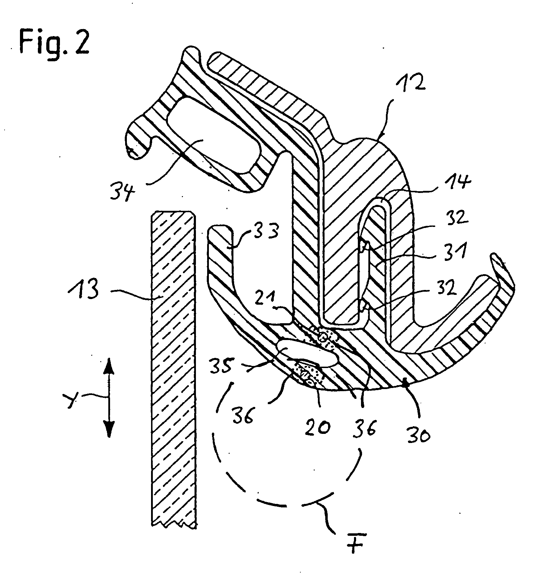

Wie Fig. 2 näher zu erkennen gibt, weist die Tür 11 einen Rahmen 12 auf, an dem eine die Fensterscheibe 13 abdichtende Dichtung 30 befestigt ist. Die aus einem elektrisch nicht leitenden, elastomeren Werkstoff, beispielsweise EPDM, gefertigte Dichtung 30 weist einen Befestigungsabschnitt 31 auf, der in einem Kanal 14 des Rahmens 12 festgelegt ist. Zu diesem Zweck ist der Befestigungsabschnitt 31 mit Haltelippen 32 versehen, die einen Kraftschluss mit den Wandungen des Kanals 14 bewirken. Die Dichtung 30 ist ferner mit Dichtlippen 33, 34 versehen, welche die Fensterscheibe 13 führen und abdichten. Die Dichtlippe 33 liegt dabei an einer Seitenfläche der Fensterscheibe 13 an, wohingegen die als Hohlkammerdichtung ausgebildete Dichtlippe 34 an die Stirnfläche der Fensterscheibe 13 stösst.

Weiterhin sind in der Dichtung 30 zwei im Querschnitt kreisförmig ausgestaltete Metallstränge eingebettet, die eine Sensorelektrode 20 und eine Grundelektrode 21 bilden. Die Sensorelektrode 20 und die Grundelektrode 21 sind durch eine Hohlkammer 35 voneinander beabstandet und jeweils von einem elektrisch leitfähigen Bereich 36, der beispielsweise durch Koextrusion gefertigt wird, umgeben.

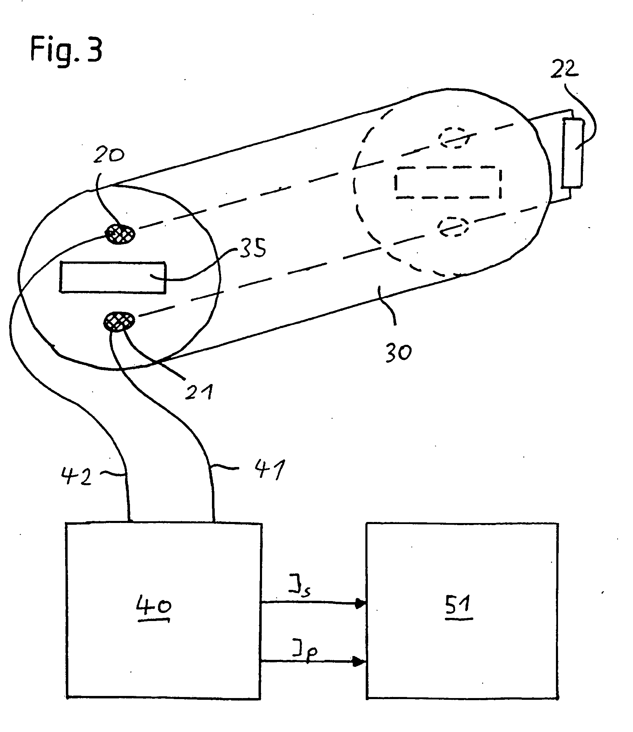

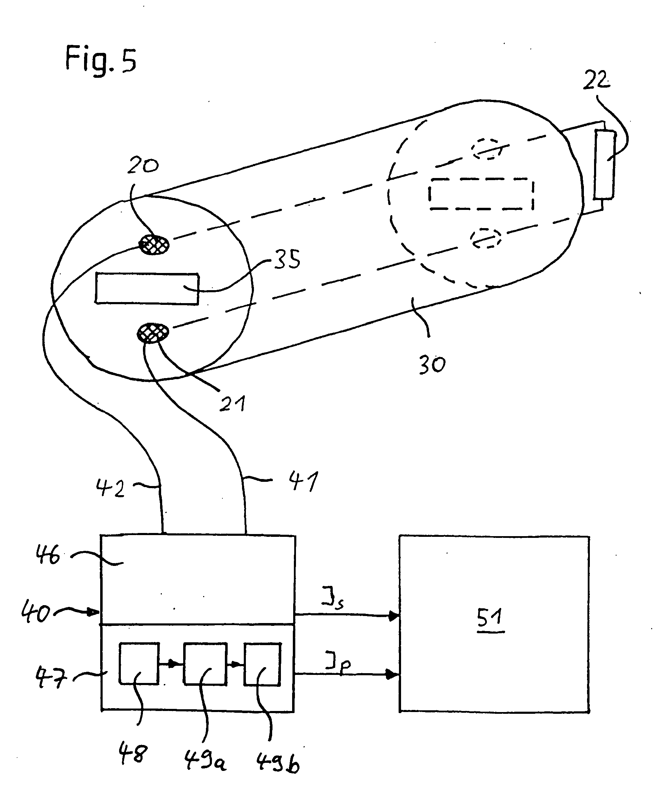

Die Sensorelektrode 20 und die Grundelektrode 21 dienen dazu, ein elektrisches Feld F in dem Öffnungsbereich der Fensterscheibe 13 zu erzeugen, wie es in der EP 1 154 110 A2 beschrieben wird. Somit ist es möglich, mittels einer in Fig. 3 und Fig. 5 gezeigten Auswerteeinheit 40, die durch Anschlussleitungen 41, 42 mit einem ersten Ende der Sensorelektrode 20 und einem ersten Ende der Grundelektrode 21 verbunden ist, eine durch die Anwesenheit eines Hindernisses in dem elektrischen Feld F hervorgerufene kapazitive Änderung in einem ersten Betriebsmodus zu erfassen, um ein Steuersignal Iₛ für eine den Elektromotor 50 steuernde Motorsteuerung 51 bereitzustellen. Das Steuersignal Iₛ stoppt im Bedarfsfall den Elektromotor 50 oder führt eine Reversion der Bewegung der Fensterscheibe 13 herbei, um ein Einklemmen des Hindernisses beispielsweise zwischen der Stirnfläche der Fensterscheibe 13 und dem Rahmen 12 zu verhindern.

Wie Fig. 2 zu erkennen gibt, ist die Sensorelektrode 20 in einem dem Öffnungsbereich der Fensterscheibe 13 zugewandten Aussenbereich der Dichtung 30 angeordnet. Auf diese Weise ist es möglich, das ein in dem Öffnungsbereich der Fensterscheibe 13 befindliches Hindernis in Kontakt mit dem die Sensorelektrode 20 aufnehmenden Aussenbereich der Dichtung 30 gelangt und diesen verformt. Die Verformung des Aussenbereichs der Dichtung 30 hat zur Folge, dass die Sensorelektrode 20 auf Grund der Hohlkammer 35 relativ zu der Grundelektrode 21 bewegt wird. Die damit einhergehende kapazitive Änderung lässt sich durch die Auswerteeinheit 40 in einem zweiten Betriebsmodus erfassen, um ein Steuersignal Iₛ zu erzeugen. Die Dichtung 30 bildet somit in dem die Sensorelektrode 20 aufnehmenden Aussenbereich einen Softspot aus.

Die Auswerteeinheit 40 ist darüber hinaus in der Lage, in dem zweiten Betriebsmodus ein Steuersignal Iₛ zu erzeugen, wenn die Hohlkammer 35 durch ein Hindernis soweit zusammengedrückt wird, dass die die Sensorelektrode 20 und die Grundelektrode 21 umgebenden elektrisch leitfähigen Bereiche 36 miteinander in Berührung kommen. Der sich auf diese Weise ergebende elektrische Kontakt von Sensorelektrode 20 und Grundelektrode 21 schafft einen taktilen Einklemmschutz, der sicherstellt, dass ein Hindernis in dem Öffnungsbereich der Fensterscheibe 13 auch dann wirksam und zuverlässig erkannt wird, wenn das elektrische Feld F elektromagnetischen Störeinflüssen unterliegt. Die Auswerteeinheit 40 kann ferner so ausgestaltet sein, dass eine bei Anwesenheit eines Hindernisses in dem Öffnungsbereich der Fensterscheibe 13 von dem Hindernis auf die Fensterscheibe 13 ausgeübte Kraft als Änderung der auf den Elektromotor 50 wirkenden Last erfasst wird. Bei Überschreiten eines vorgegebenen Maximalwerts für die Kraft beziehungsweise für die durch den Elektromotor 50 fliessende Stromstärke, die in der Regel proportional zu der von dem Hindernis auf die Fensterscheibe 13 ausgeübten Kraft ist, stellt die Auswerteeinheit 40 ein Steuersignal Iₛ für die Motorsteuerung 51 bereit.

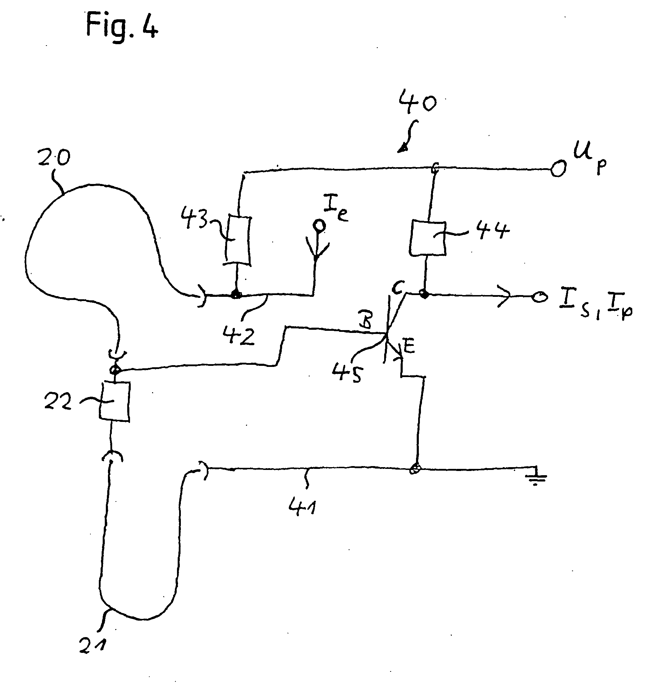

Wie aus Fig. 3 ersichtlich ist, sind die Sensorelektrode 20 und die Grundelektrode 21 an einem den Anschlussleitungen 41, 42 abgewandten zweiten Ende durch ein elektronisches Bauelement miteinander verbunden, das einen Überwachungswiderstand 22 darstellt. Der als Drossel wirkende Überwachungswiderstand 22 ermöglicht, eine Prüfspannung Uₚ an die Sensorelektrode 20 und die Grundelektrode 21 anzulegen, wie es das Schaltbild gemäss Fig. 4 zeigt. Durch die Prüfspannung Uₚ ist es möglich, die Funktionsfähigkeit von Sensorelektrode 20 und Grundelektrode 21 permanent zu überwachen. Bei einer Funktionsstörung, beispielsweise in Folge einer Unterbrechung oder eines Kurzschlusses, wird ein Steuersignal Iₚ für die Motorsteuerung 51 bereitgestellt und gegebenenfalls ein Warnhinweis ausgelöst.

Der in Fig. 4 dargestellte Schaltplan gibt zu erkennen, dass die Auswerteeinheit 40 über einen vergleichsweise einfachen Aufbau verfügt, der sich aus einigen wenigen Widerständen 43, 44 und einem Transistor 45 zusammensetzt. Trotz dieses einfachen Aufbaus ermöglicht die Auswerteeinheit 40 ein Sensorsignal Iₑ auf die Sensorelektrode 20 zu geben, um durch das auf diese Weise erzeugte elektrische Feld F einen kapazitiven Einklemmschutz zu realisieren. Der Aufbau der Auswerteeinheit 40 gestattet zugleich, den kapazitiven Einklemmschutz mit einem taktilen Einklemmschutz zu kombinieren, um eine hohe Betriebs- und Ausfallsicherheit zu erreichen.

Wie Fig. 5 zu erkennen zu erkennen gibt, kann die Auswerteeinheit 40 eine Sensorelektronik 46, die das Erkennen eines Hindernisses auf Grund einer kapazitiven Änderung ermöglicht, und eine Sensorelektronik 47, die das Erkennen eines Hindernisses auf Grund eines elektrischen Kontakts von Sensorelektrode 20 und Grundelektrode 21 ermöglicht, aufweisen. Die Sensorelektronik 47 ist eine analoge Schaltung, die sich aus einem Operationsverstärker 48, einer Vorstufe 49a und einer Endstufe 49b zusammensetzt und sich durch eine vergleichsweise schnelle Reaktionszeit und die Unabhängigkeit von der Motorsteuerung 51 auszeichnet.

Zu einer hohen Betriebs- und Ausfallsicherheit trägt auch der sich durch die Ausgestaltung der Dichtung 30 ergebende Softspot und die aktive Redundanz in Folge der indirekten Erfassung des Hindernisses durch die auf den Elektromotor 50 wirkende Last bei. Die sich danach durch eine hohe Zuverlässigkeit auszeichnende Vorrichtung zum Erkennen eines Hindernisses kann nicht nur als Einklemmschutz für die Fensterscheibe 13 Anwendung finden, sondern auch für andere Schliesselemente des Kraftfahrzeugs 10, beispielsweise ein Schiebedach, eine Heckklappe oder ein Kofferraumdeckel, eingesetzt werden.

### Bezugszeichenliste

- 10: Kraftfahrzeug
- 11: Tür
- 12: Rahmen
- 13: Fensterscheibe
- 14: Kanal

- 20: Sensorelektrode
- 21: Grundelektrode
- 22: Überwachungswiderstand

- 30: Dichtung
- 31: Befestigungsabschnitt
- 32: Haltelippe
- 33: Dichtlippe
- 34: Dichtlippe
- 35: Hohlkammer
- 36: elektrisch leitfähiger Bereich

- 40: Auswerteeinheit
- 41: Anschlussleitung
- 42: Anschlussleitung
- 43: Widerstand
- 44: Widerstand
- 45: Transistor
- 46: Sensorelektronik
- 47: Sensorelektronik
- 48: Operationsverstärker
- 49a: Vorstufe
- 49b: Endstufe

- 50: Elektromotor
- 51: Motorsteuerung

- F: elektrisches Feld
- Iₑ: Sensorsignal
- Iₛ: Steuersignal
- Iₚ: Steuersignal
- Uₚ: Prüfspannung
- y: Antriebsrichtung

## Patentansprüche

1. Vorrichtung zum Erkennen eines Hindernisses in dem Öffnungsbereich eines bewegbaren Schliesselements (13), insbesondere einer elektrisch angetriebenen Fensterscheibe (13) oder eines Schiebedachs eines Kraftfahrzeugs (10), mit
einer Sensorelektrode (20), die ein erstes Ende und ein zweites Ende aufweist;
einer von der Sensorelektrode (20) beabstandeten Grundelektrode (21), die ein erstes und ein zweites Ende aufweist, und
einer mit dem ersten Ende der Sensorelektrode (20) und mit dem ersten Ende der Grundelektrode (21) verbundenen Auswerteeinheit (40);
wobei die Sensorelektrode (20) und die Grundelektrode (21) ein elektrisches Feld (F) in dem Öffnungsbereich des Schliesselements (13) erzeugen;
wobei die Sensorelektrode (20) und die Grundelektrode (21) in einem ersten Betriebsmodus einen konstanten Abstand zueinander aufweisen;
wobei die Auswerteeinheit (40) in dem ersten Betriebsmodus eine auf Grund der Anwesenheit eines Hindernisses in dem elektrischen Feld (F) hervorgerufene kapazitive Änderung erfasst und ein Steuersignal (Iₛ, Iₚ) für einen das Schliesselement (13) bewegenden Antrieb (50) bereitstellt;
wobei die Sensorelektrode (20) und die Grundelektrode (21) an dem zweiten Ende durch ein elektronisches Bauelement (22) miteinander verbunden sind;
wobei eine Prüfspannung (Up) an die Sensorelektrode (20) und die Grundelektrode (21) angelegt ist;
wobei die Sensorelektrode (20) und die Grundelektrode (21) in einem zweiten Betriebsmodus einen veränderlichen Abstand zueinander aufweisen und
wobei die Auswerteeinheit (40) in dem zweiten Betriebsmodus bei einem elektrischen Kontakt von Sensorelektrode (20) und Grundelektrode (21) ein Steuersignal (Iₛ) für den das Schliesselement (13) bewegenden Antrieb (50) bereitstellt.

2. Vorrichtung nach Anspruch 1, **dadurch gekennzeichnet, dass** die Auswerteeinheit (40) in dem zweiten Betriebsmodus bei einer Veränderung der relativen Lage von Sensorelektrode (20) und Grundelektrode (21) ein Steuersignal (Iₛ) für den das Schliesselement (13) bewegenden Antrieb (50) bereitstellt.

3. Vorrichtung nach Anspruch 1 oder 2, **dadurch gekennzeichnet, dass** das elektronische Bauelement (22) einen ohmschen und/oder induktiven und/oder kapazitiven Widerstand aufweist.

4. Vorrichtung nach einem der Ansprüche 1 bis 3, **gekennzeichnet durch** eine das Schliesselement (13) abdichtende Dichtung (30), die aus einem elastisch verformbaren Werkstoff, vorzugsweise Ethylen-Propylen-Dien-Kautschuk, gefertigt und an einem das Schliesselement (13) zumindest teilweise einfassenden Rahmen (12) befestigt ist.

5. Vorrichtung nach Anspruch 4, **dadurch gekennzeichnet, dass** die Dichtung (30) einen Befestigungsabschnitt (31), der an dem Rahmen (12) angeordnet ist, und wenigstens eine Dichtlippe (33, 34), die an dem Schliesselement (13) anliegt, aufweist.

6. Vorrichtung nach Anspruch 4 oder 5, **dadurch gekennzeichnet, dass** die Sensorelektrode (20) und/oder die Grundelektrode (21) als Metallstränge ausgestaltet sind, die in die Dichtung (30) eingebettet und durch eine Hohlkammer (35) voneinander beabstandet sind.

7. Vorrichtung nach Anspruch 6, **dadurch gekennzeichnet, dass** die Metallstränge (20, 21) im Querschnitt rund, vorzugsweise kreisförmig oder oval, oder polygonal, vorzugsweise rechteckig oder dreieckig, ausgebildet sind.

8. Vorrichtung nach Anspruch 6 oder 7, **dadurch gekennzeichnet, dass** die Sensorelektrode (20) und/oder die Grundelektrode (21) von elektrisch leitfähigen Bereichen (36) der Dichtung (30), die durch die Hohlkammer (35) voneinander beabstandet sind, umgeben sind.

9. Vorrichtung nach Anspruch 4 oder 5, **dadurch gekennzeichnet, dass** die Sensorelektrode (20) und/oder die Grundelektrode (21) als elektrisch leitfähige Bereiche der Dichtung (30) ausgestaltet sind, die durch eine Hohlkammer (35) voneinander beabstandet sind.

10. Vorrichtung nach einem der Ansprüche 1 bis 9, **dadurch gekennzeichnet, dass** die Auswerteeinheit (40) eine bei Anwesenheit eines Hindernisses in dem Öffnungsbereich des Schliesselements (13) von dem Hindernis auf das Schliesselement (13) ausgeübte Kraft erfasst und bei Überschreiten eines vorgegeben Maximalwerts für die Kraft ein Steuersignal (Iₛ) für den das Schliesselement (13) bewegenden Antrieb (50) bereitstellt.

## Claims

1. Device for detecting an obstacle in the opening area of a movable closing element (13), in particular an electrically-driven window pane (13) or a sliding roof of a motor vehicle (10) having
a sensor electrode (20) having a first end and a second end;
a ground electrode (21), having a first and a second end, positioned at a distance from the sensor electrode (20),
an evaluation unit (40) connected to the first end of the sensor electrode (20) and to the first end of the ground electrode (21);
wherein the sensor electrode (20) and the ground electrode (21) generate an electric field (F) in the opening area of the closing element (13);
wherein the sensor electrode (20) and the ground electrode (21) in a first operating mode are at a constant distance from each other;
wherein the evaluation unit (40) in the first operating mode records a capacitive change caused by the presence of an obstacle in the electric field (F) and provides a control signal (Iₛ, Iₚ) for a drive (50) that moves the closing element (13);
wherein the sensor electrode (20) and the ground electrode (21) are connected to each other at the second end by an electronic component (22);
wherein a test voltage (Up) is applied to the sensor electrode (20) and the ground electrode (21);
wherein the sensor electrode (20) and the ground electrode (21) in a second operating mode are at a varying distance from each other and
wherein the evaluation unit (40) in the second operating mode provides a control signal (Iₛ) for the drive (50) that moves the closing element (13) when an electric contact arises between the sensor electrode (20) and the ground electrode (21).

2. Device according to claim 1 **characterised in that** the evaluation unit (40) in the second operating mode provides a control signal (Iₛ) for the drive (50) that moves the closing element (13) when there is a change in the relative position of the sensor electrode (20) and the ground electrode (21).

3. Device according to claim 1 or 2 **characterised in that** the electronic component (22) is provided with an ohmic and/or inductive and/or capacitive resistance.

4. Device according to one of the claims 1 to 3 **characterised by** a seal (30) for the closing element (13) which is made of an elastically mouldable substance, preferably ethylene propylene diene rubber, and is secured to a frame (12) at least partly surrounding the closing element (13).

5. Device according to claim 4 **characterised in that** the seal (30) is provided with a securing section (31) arranged on the frame (12) and at least one sealing lip (33, 34) fitting closely against the closing element (13).

6. Device according to claim 4 or 5 **characterised in that** the sensor electrode (20) and/or the ground electrode (21) are configured as metal threads embedded in the seal (30) and which are spaced apart from each other by a hollow chamber (35).

7. Device according to claim 6 **characterised in that** the metal threads (20, 21) have a round cross-section, preferably circular or oval, or polygonal, preferably square or triangular.

8. Device according to claim 6 or 7 **characterised in that** the sensor electrode (20) and/or the ground electrode (21) are surrounded by electrically conductive areas (36) of the seal (30) which are spaced apart from each other by the hollow chamber (35).

9. Device according to claim 4 or 5 **characterised in that** the sensor electrode (20) and/or the ground electrode (21) are configured as electrically conductive areas of the seal (30) spaced apart by a hollow chamber (35).

10. Device according to one of the claims 1 to 9 **characterised in that** the evaluation unit (40) records a force exerted by an obstacle on the closing element (13) when there is an obstruction present in the opening area of the closing element (13) and, if a prescribed maximum value for the said force is exceeded, provides a control signal (Iₛ) for the drive (50) moving the closing element (13).

## Revendications

1. Dispositif pour reconnaître un obstacle dans la zone d'ouverture d'un élément de fermeture déplaçable (13), en particulier d'une vitre de fenêtre à entraînement électrique (13) ou d'un toit coulissant d'un véhicule automobile (10), comprenant :
une électrode de détection (20) qui présente une première extrémité et une seconde extrémité ;
une électrode de base (21), à distance de l'électrode de détection (20), qui présente une première extrémité et une seconde extrémité ; et
une unité d'évaluation (40) reliée à la première extrémité de l'électrode de détection (20) et à la première extrémité de l'électrode de base (21) ;
dans lequel l'électrode de détection (20) et l'électrode de base (21) engendrent un champ électrique (F) dans la zone d'ouverture de l'élément de fermeture (13) ;
dans lequel l'électrode de détection (20) et l'électrode de base (21) sont à une distance constante l'une de l'autre dans un premier mode de fonctionnement ;
dans lequel l'unité d'évaluation (40) détecte dans le premier mode de fonctionnement une modification capacitive provoquée en raison de la présence d'un obstacle dans le champ électrique (F) et prépare un signal de commande (Is, Ip) pour un entraînement (50) qui déplace l'élément de fermeture (13) ;
dans lequel l'électrode de détection (20) et l'électrode de base (21) sont reliées l'une à l'autre à la seconde extrémité par un composant électronique (22) ;
dans lequel une tension de contrôle (Up) est appliquée à l'électrode de détection (20) et à l'électrode de base (21) ;
dans lequel l'électrode de détection (20) et l'électrode de base (21) sont l'une par rapport à l'autre à une distance variable dans un second mode de fonctionnement ; et
dans le second mode de fonctionnement, l'unité d'évaluation (40) prépare, lors d'un contact électrique de l'électrode de détection (20) et l'électrode de base (21), un signal de commande (Is) pour l'entraînement (50) qui déplace l'élément de fermeture (13).

2. Dispositif selon la revendication 1, **caractérisé en ce que,** dans le second mode de fonctionnement, l'unité d'évaluation (40) prépare, lors d'une variation de la position relative de l'électrode de détection (20) et de l'électrode de base (21), un signal de commande (Is) pour l'entraînement (50) qui déplace l'élément de fermeture (13).

3. Dispositif selon la revendication 1 ou 2, **caractérisé en ce que** le composant électronique (22) présente une résistance ohmique et/ou inductive et/ou capacitive.

4. Dispositif selon l'une des revendications 1 à 3, **caractérisé par** un joint (30) qui étanche l'élément de fermeture (13), fabriqué en un matériau élastiquement déformable, de préférence un caoutchouc éthylène-propylène-diène, et fixé sur un cadre (12) qui enchâsse au moins partiellement l'élément de fermeture (13).

5. Dispositif selon la revendication 4, **caractérisé en ce que** le joint (30) comprend un tronçon de fixation (31), qui est agencé sur le cadre (12), et au moins une lèvre d'étanchéité (33, 34) qui est appliquée contre l'élément de fermeture (13).

6. Dispositif selon la revendication 4 ou 5, **caractérisé en ce que** l'électrode de détection (20) et/ou l'électrode de base (21) sont conçues sous forme de rubans métalliques, qui sont noyés dans le joint (30) et écartés l'un de l'autre par une chambre creuse (35).

7. Dispositif selon la revendication 6, **caractérisé en ce que** les rubans métalliques (20, 21) sont réalisés avec une section transversale ronde, de préférence de forme circulaire ou ovale, ou polygonale, de préférence rectangulaire ou triangulaire.

8. Dispositif selon la revendication 6 ou 7, **caractérisé en ce que** l'électrode de détection (20) et/ou l'électrode de base (21) sont entourées par des zones électriquement conductrices (36) du joint (30) qui sont écartées l'une de l'autre par la chambre creuse (35).

9. Dispositif selon la revendication 4 ou 5, **caractérisé en ce que** l'électrode de détection (20) et/ou l'électrode de base (21) sont conçues comme des zones électriquement conductrices du joint (30), qui sont écartées l'une de l'autre par une chambre creuse (35).

10. Dispositif selon l'une des revendications 1 à 9, **caractérisé en ce que** l'unité d'évaluation (40) détecte, en cas de présence d'un obstacle dans la zone d'ouverture de l'élément de fermeture (13), une force exercée par l'obstacle sur l'élément de fermeture (13) et, lors d'un dépassement d'une valeur maximum prédéterminée pour la force, elle prépare un signal de commande (Is) pour l'entraînement (50) qui déplace l'élément de fermeture (13).
